Europäisches Patentamt

European Patent Office

Office européen des brevets

(11) Publication number: **0 476 530 A1**

# EUROPEAN PATENT APPLICATION

(21) Application number: **91115513.3**

(22) Date of filing: **13.09.91**

(51) Int. Cl.5: **H03K 5/15, H03K 5/159**

(30) Priority: **21.09.90 US 586126**

(43) Date of publication of application:
**25.03.92 Bulletin 92/13**

(84) Designated Contracting States:
**DE FR GB IT**

(71) Applicant: **Intergraph Corporation**
**One Madison Industrial Park**
**Huntsville, Alabama 35807-4201(US)**

(72) Inventor: **Herndon,William H.**
**1056 Yorktown Drive**
**Sunnyvale ,CA 94087(US)**

(74) Representative: **Sparing Röhl Henseler**
**Patentanwälte European Patent Attorneys**
**Rethelstrasse 123**
**W-4000 Düsseldorf 1(DE)**

(54) Apparatus for distributing clock pulses.

(57) A plurality of transmission lines communicate potentially skewed clock pulses from a source of clock pulses. A combining transmission line is coupled to the plurality of transmission lines at a common node. The impedance of the combining transmission line is chosen to be substantially equal to the parallel impedances of the plurality of transmission lines to prevent reflections which degrade the clock signal. As a result, the combining transmission line combines the received clock pulses into a single clock pulse. A plurality of distribution lines are thereafter coupled to the combining transmission line at a single node. The parallel impedances of the plurality of distribution lines are chosen to be substantially equal to the impedance of the combining transmission line, once again to prevent reflections which would degrade the clock signal. The plurality of distribution lines then communicate the single clock pulses to their associated clock driven circuitry.

FIG. 1.

This invention relates to electrical circuits and, more particularly, to an apparatus for distributing clock pulses.

Many elements in electrical circuits are driven by clock pulses to insure that the elements perform their respective functions at the appropriate time in an overall processing sequence. The clock pulses typically are derived from a master clock generator and are distributed to the clock driven elements using different methods. One method uses a plurality of amplifiers, each having an input terminal connected to a common node for receiving clock pulses from the clock signal source. The output terminal of each amplifier provides the clock signal to an associated set of clock driven elements. Unfortunately, signal propagation delays through the amplifiers are variable because of production tolerances, etc. This creates a timing skew among the clock pulses output from the amplifiers. Thus, there is no guarantee that circuit elements which are coupled to different amplifiers and which must receive a particular clock pulse at the same time will in fact receive the clock pulse at the required time.

One approach to minimizing the effect of clock signal skew on the clock-driven components involves combining skewed clock signals into a single clock pulse which then may be distributed to the clock-driven elements which require it. One technique, not necessarily in the prior art, includes the use of a transformer. A plurality of transmission lines, each carrying potentially skewed clock pulses, form the primary winding of the transformer, and a plurality of distribution lines form the secondary winding of the transformer. The transformer core provides an analog summation of the clock pulses received from the transmission lines and produces single clock pulses at the secondary windings. The distribution lines thereafter communicate the single pulses to their associated electronic elements. While this technique works for clock pulses having periods in the nanosecond range, it is unsuitable for clock pulses having periods in the picosecond range.

The present invention as defined by the independent claims is directed to an apparatus for distributing clock signals wherein multiple clock pulses are combined into a single pulse in a manner which supports clock periods on the order of picoseconds. In one embodiment of the present invention, a plurality of transmission lines communicate potentially skewed clock pulses from a source of clock pulses. A combining transmission line is coupled to the plurality of transmission lines at a common node. The impedance of the combining transmission line is chosen to be substantially equal to the parallel impedances of the plurality of transmission lines to prevent reflections which degrade the clock signal. As a result, the combining transmission line combines the received clock pulses into a single clock pulse. A plurality of distribution lines are thereafter coupled to the combining transmission line at a single node. The parallel impedances of the plurality of distribution lines are chosen to be substantially equal to the impedance of the combining transmission line, once again to prevent reflections which would degrade the clock signal. The plurality of distribution lines then communicate the single clock pulses to their associated clock driven circuitry.

Fig. 1 is a diagram of a particular embodiment of an apparatus for distributing clock pulses according to the present invention.

Fig. 2 is a diagram showing a clock pulse according to the present invention which is derived from two skewed clock pulses.

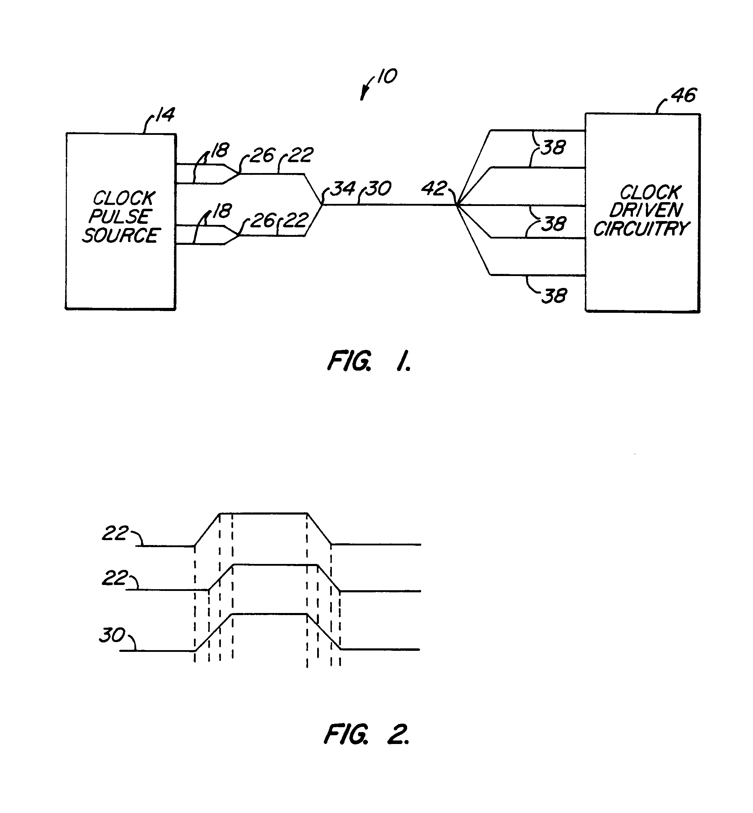

Fig. 1 is a diagram showing a particular embodiment of a clock distributing circuit 10 according to the present invention. A clock pulse source 14 produces clock pulses (possibly skewed in time) on a plurality of transmission lines 18. Typically, clock pulse source 14 includes a master clock generator (not shown) which provides clock signals to analog or digital circuit elements (not shown) which, in turn, provide clock pulses on transmission lines 18. Transmission lines 18 are coupled to a plurality of lines 22 at common nodes 26, and lines 22 are connected to a line 30 at a common node 34.

The impedances of lines 22 are chosen to match the parallel impedance of the transmission lines 18 to which they are attached. For example, if each transmission line 18 shown has an impedance of 50 ohms, then each line 22 will have an impedance of 25 ohms. Similarly, line 30 is chosen to have an impedance which substantially matches the parallel impedance of the lines 22 to which it is attached. Thus, in the example noted above, line 30 would have an impedance of 12.5 ohms.

By matching impedances in this way, signal reflections at nodes 26 and 34 are avoided. As a result, the signals on lines 22 are an accurate combination of the clock pulses received from transmission lines 18, and the signals on line 30 are an accurate combination of clock pulses received from lines 22. Thus, lines 22 may be considered combining transmission lines relative to transmission lines 18, and line 30 may be considered a combining transmission line relative to lines 22. In the latter case, lines 22 may also be considered transmission lines.

Combining transmission line 30 is coupled to a plurality of distribution lines 38 at a common node 42. The parallel impedance of distribution lines 38 is chosen to match the impedance of combining transmission line 30 to prevent signal reflections at node 42. Thus, a clock pulse appearing at node 42 will be communicated along distribution lines 38 so that the rising and falling edges of the resulting plurality of clock pulses occur at the same time. The clock pulses are thereafter used by clock driven circuitry 46.

Fig. 2 is a timing diagram showing how clock pulses are combined according to the present invention. For illustrative purposes, Fig. 2 shows a clock pulse on each line 22 being combined into one clock pulse on combining transmission line 30. The clock pulses on transmission lines 18 are combined on lines 22 in the same way. As shown in Fig. 2, the timing of pulses on lines 22 are skewed relative to each other. However, the pulses on lines 22 are combined by combining transmission line 30 into a single pulse. Although the leading and trailing edge portions of the combined pulse are longer than the original pulses, that is acceptable for most purposes since the leading and trailing edges of the pulses will occur at the same time when received by clock driven circuitry 46.

While the above is a description of preferred embodiment of the present invention, various modifications may be employed. For example, distribution lines 38 may be formed into a multiple level hierarchy as lines 18 and 22. Consequently, the scope of the invention should not be limited except as described in the claims.

**Claims**

1. An apparatus for distributing clock pulses comprising:
   a plurality of transmission lines for communicating clock pulses from a source of clock pulses;
   a combining transmission line, coupled to the plurality of transmission lines, for receiving the clock pulses from the plurality of transmission lines so that the clock pulses from the plurality of transmission lines are combined by the combining transmission line into a combined clock signal.

2. The apparatus according to claim 1 wherein the combining transmission line has an impedance substantially equal to a parallel impedance of the plurality of transmission lines.

3. The apparatus according to claim 2 wherein the combining transmission line is coupled to the plurality of transmission lines at a common node.

4. The apparatus according to claim 3 wherein clock pulses communicated along each transmission line reach the node at approximately the same time.

5. The apparatus according to claim 2 further comprising a plurality of distribution lines coupled to the combining transmission line.

6. The apparatus according to claim 5 wherein a parallel impedance of the plurality of distribution lines is substantially equal to the impedance of the combining transmission line.

7. The apparatus according to claim 6 wherein the plurality of distribution lines are coupled to the combining transmission lines at a common node.

8. An apparatus for distributing clock pulses comprising:
   a plurality of transmission lines for communicating a source of clock pulses;
   a single combining transmission line connected to the plurality of transmission lines at a first common node, the combining transmission line having an impedance equal to a parallel impedance of the plurality of transmission lines; and
   wherein the clock pulses are communicated along the plurality of transmission lines for reaching the node at approximately the same time so that the clock pulses from the plurality of transmission lines are combined by the combining transmission line into a combined clock signal.

9. The apparatus according to claim 8 further comprising:
   a plurality of distribution lines coupled to the combining transmission line at a second common node, a parallel impedance of the plurality of distribution lines being substantially equal to the impedance of the combining transmission line.

10. An apparatus for distributing clock pulses comprising:
    a single transmission line for communicating a source of clock pulses; and
    a plurality of distribution lines connected to the transmission line at a common node, a parallel impedance of the plurality of distribution lines being substantially equal to the impedance of the transmission line.

11. A method of communicating clock pulses comprising the steps of:
    communicating a source of clock pulses along a plurality of transmission lines;

coupling the plurality of transmission lines to a combining transmission line so that a parallel impedance of the plurality of transmission lines is substantially equal to an impedance of the combining transmission line;

receiving the clock pulses from the plurality of transmission lines by the combining transmission line so that the clock pulses from the plurality of transmission lines are combined into a combined clock signal by the combining transmission line.

12. The method according to claim 11 wherein the step of coupling the plurality of transmission lines further comprises the step of coupling the plurality of transmission lines to the combining transmission line at a common node.

13. The method according to claim 12 further comprising the step of communicating the clock pulses along the plurality of transmission lines so that clock pulses on each transmission line reach the node at approximately the same time.

14. The method according to claim 11 further comprising the step of coupling a plurality of distribution lines to the combining transmission line so that a parallel impedance of the plurality of distribution lines is substantially equal to the impedance of the combining transmission line.

15. The method according to claim 14 wherein the step of coupling the plurality of distribution lines further comprises the step of coupling the plurality of distribution lines to the combining transmission lie at a common node.

16. A method of distributing clock pulses comprising the steps of:

communicating a source of clock pulses along a single transmission line; and

coupling the transmission line to a plurality of distribution lines so that a parallel impedance of the plurality of distribution lines is substantially equal to an impedance of the transmission line.

FIG. 1.

FIG. 2.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | THE IEEE COMPUTER SOCIETY, INTERNATIONAL TEST CONFERENCE 1989 PROCEEDINGS, MEETING THE TESTS OF TIME 29 August 1989, PHILADELPHIA pages 199 - 207; C.-W. HSUE: 'CLOCK SIGNAL DISTRIBUTION NETWORK FOR HIGH SPEED TESTERS'<br>– – – | 10,16 | H 03 K 5/15<br>H 03 K 5/159 |
| Y | * the whole document *<br>– – – | 1-9,11-15 | |
| Y | US-A-3 490 054   (H.SEIDEL ET AL.)<br>* abstract; figures 1,3,6-8 * *<br>– – – | 1-9,11-15 | |
| A | GB-A-1 033 962   (SPERRY RAND CORPORATION)<br>– – – – – | | |

| | TECHNICAL FIELDS SEARCHED (Int. Cl.5) |
|---|---|
| | H 03 K<br>H 03 H |

The present search report has been drawn up for all claims

| Place of search | Date of completion of search | Examiner |
|---|---|---|
| The Hague | 06 December 91 | SEGAERT P.A.O.M.P. |